# EUROPÄISCHE PATENTSCHRIFT

(11) **EP 1 840 242 B1**
(45) Veröffentlichungstag und Bekanntmachung des Hinweises auf die Patenterteilung: **29.06.2011**
(21) Anmeldenummer: 06111908.7
(22) Anmeldetag: 29.03.2006
(51) Int. Cl.: C23C 16/458

(54) **Vakuumtransportvorrichtung mit beweglicher Führungsschiene**
Void apparatus with a movable guiding rail
Dispositif de transport sous vide avec un rail de guidage déplaçable

(43) Veröffentlichungstag der Anmeldung: 03.10.2007
(73) Patentinhaber: Applied Materials GmbH & Co. KG, 63755 Alzenau (DE)
(72) Erfinder: Heimel, Oliver, 34590 Wabern (DE); Jischke, Andreas, 63796, Kahl (DE); Haas, Dieter, 63486 Bruchköbel (DE)
(74) Vertreter: Lang, Christian

(56) Entgegenhaltungen:
- DE-U1- 29 514 989
- US-A- 3 347 655
- US-A- 5 909 995
- US-B1- 6 432 206
- US-B1- 6 863 735

## Beschreibung

### Technisches Gebiet

Die vorliegende Erfindung betrifft eine Vorrichtung zum Transport von Substraten durch Vakuumkammern, insbesondere Beschichtungsanlagen mit einem Substratträger, auf oder an dem das Substrat angeordnet werden kann, wobei der Substratträger mindestens eine Führungsschiene aufweist, die sich entlang mindestens einer Seite des Substraträgers erstreckt.

### Stand der Technik

Aus der CH 691 680 A5 bzw. der DE 297 15 535 U1 ist eine Transportvorrichtung für Werkstücke in einer Vakuumanlage bekannt, bei welcher die Substratträger für insbesondere flache und großflächige Substrate, wie Glasscheiben auf einem entsprechenden platten-, scheiben- oder rahmenartigen Substratträger angeordnet werden können, wobei der Substratträger an seiner Oberseite Permanentmagnete aufweist, die mit einer ebenfalls mit Magneten versehenen weichmagnetischen, U-förmigen Halterung zusammen wirken, so dass der Substratträger an seiner Oberseite berührungslos geführt wird.

Obwohl diese Lösung bereits sehr gute Ergebnisse liefert, führt die Anordnung der Magnetschiene an dem restlichen Substratträger, beispielsweise einer Carrier-Platte oder einer Rahmenanordnung zu der Problematik, dass es bei großflächigen Substraten mit bestimmten Dimensionen des Substratträgers durch die unterschiedliche Erwärmung der Bauteile, nämlich Magnetführungsschiene einerseits und Carrier andererseits, insbesondere bei zyklisch wiederkehrenden Erwärmungen, wie häufig bei Beschichtungsanlagen der Fall, zu einem Reiben der Bauteile des Substratträgers gegeneinander kommt Außerdem werden durch die Belastungen der großflächigen Substrate bzw. Substratträger beim Transport undefinierte Verformungen, wie Torsion des gesamten Carriers, Biegung der Platten usw. eingebracht, die zu einer weiteren Relativbewegung der Magnetführungsschiene und des Substratträgers bzw. des Carriers einerseits sowie zu Reibkontakten mit und zum Schleifen oder Anstoßen an der magnetischen Halterung, in der der Substratträger mit seiner Magnetführungsschiene in der Anlage normalerweise berührungslos geführt wird, andererseits führen können, so dass ein unter Umständen nicht unerheblicher Abrieb erzeugt werden kann, der sich nachteilig auf die Qualität der darin durchgeführten Beschichtungen auswirken kann.

Weitere Vorrichtungen zur Halterung von Substraten sind in den Dokumenten DE 295 149 89 U1, US 6,863,735 B1, US 6,432,206 B1 und US 3,347,655 gebannt. Hierbei zeigt die DE 295 149 89 U1 einen Substratträger, der über ein Fußteil fest mit Schienen gekoppelt ist, während die US 6,863,735 B1 und die US 6,432,206 B1 drehbar gelagerte Substratträger zeigen, die jedoch nicht für den Transport eines Substrats durch Vakuumkammern geeignet sind. Die US 3,347,655 zeigt einen konventionellen Substratträger, der über Rollen hängend an einer Schienenanordnung bewegbar ist.

### Technische Aufgabe

Es ist deshalb Aufgabe der vorliegenden Erfindung dieser Problematik abzuhelfen und insbesondere eine Verringerung der Verschmutzung einer Vakuumkammer durch die Führung des Substratträgers an seiner Oberseite zu vermeiden. Gleichzeitig soll die bereit zu stellende Lösung einfach zu realisieren und zuverlässig sowie kostengünstig anzuwenden sein.

### Technische Lösung

Diese Aufgabe wird gelöst mit einer Vorrichtung mit den Merkmalen des Anspruchs 1. Vorteilhafte Ausgestaltungen sind Gegenstand der abhängigen Ansprüche.

Gemäß der vorliegenden Erfindung wird die obige Aufgabe dadurch gelöst, dass die Führungsschiene so an dem Substratträger angeordnet ist, dass sie durch ein oder einige wenige Lager beabstandet zum Substratträger gehalten ist, so dass bei unterschiedlicher Verformung von Führungsschiene und restlichem Substratträger in Folge von Temperatur- und Prozesseinflüssen keine gegenseitigen Reibflächen oder nur geringe bzw. definierte Reibflächen vorhanden sind, so dass der Abrieb verringert bzw. verhindert werden kann. Darüber hinaus bietet eine derartige Lösung die Möglichkeit eine Verwindung oder Verformung bzw. allgemein Bewegung des Substratträgers zuzulassen, während gleichzeitig die Führungsschiene in der magnetischen Halterung des Transportsystems unverformt bewegt werden kann, so dass es zu keinen Kollisionen des Substratträgers bzw. der Führungsschiene mit den übrigen Anlagen teilen, insbesondere kein Schleifen der Führungsschiene an der Gegenschiene im magnetischen Transport- oder Haltesystem kommt. Auf diese Weise kann ebenfalls der Abrieb deutlich vermindert oder gänzlich verhindert werden. Außerdem können so Fertigungsungenauigkeiten ausgeglichen oder größere Fertigungstoleranzen zugelassen werden.

Bei vorzugsweise flachen platten-, scheiben- und/oder rahmenartigen Substratträgern, auf oder an welchen großflächige, flache Substrate, insbesondere großflächige Glassubstrate, wie z.B. für die Displayherstellung oder für Architekturverglasungen angeordnet werden können, wird bevorzugt die Führungsschiene entlang einer Längsseite des Substratträgers in Längsrichtung angeordnet, wobei es hier vorteilhaft ist, die Führungsschiene mittig oder in einem Zentralbereich am Substratträger zu lagern, vorzugsweise über ein einziges mittiges oder zentrales Lager. Dies hat den Vorteil, dass keine zusätzlichen Lagerbewegungen zu befürchten oder zu berücksichtigen sind.

Bei der Anordnung des mittigen oder zentralen Lagers kann der Anordnungsbereich um die zentrale Symmetrieachse herum entsprechend den sonstigen Anforderungen in einem weiten Bereich gewählt werden. Eine weitgehend mittige oder zentrale Anordnung ist jedoch vorteilhaft, da dadurch eine gleichmäßige und symmetrische Lagerung der Führungsschiene ermöglicht wird.

Das mittige oder zentrale Lager kann ein Fest- oder Loslager, insbesondere Drehlager sein.

Bei einem Festlager wird eine steife und starre Verbindung zwischen Führungsschiene und dem restlichen Substratträger vorgenommen, wobei eine unterschiedliche Bewegung oder Verformung von Führungsschiene und übrigen Substratträger im Wesentlichen in diesen Komponenten durchgeführt oder abgebaut wird. Hierbei hat es sich als vorteilhaft erwiesen, wenn insbesondere das mit dem Festlager verbundene Substratträgerteil, insbesondere ein entsprechendes Rahmenteil aus einem elastischen Werkstoff gefertigt wird, um dort die unterschiedlichen Verformungen zu ermöglichen. Insbesondere hat es sich als vorteilhaft erwiesen eine dünne "weiche" metallische Platte, beispielsweise eine Aluminiumplatte, mit einer Dicke von ca. 12 mm vorzusehen, die wie eine Blattfeder wirkt.

Alternativ kann das mittige oder zentrale Lager auch ein Loslager, insbesondere Drehlager sein, welches durch seine Lagereigenschaft eine bestimmte Bewegung von Führungsschiene im Verhältnis zum übrigen Substratträger ermöglicht. Ein derartiges loses Lager kann vorzugsweise ein Drehlager sein, dessen Drehachse in der Ebene des Substratträgers liegt und/oder im Wesentlichen senkrecht zur Seite, insbesondere Oberseite des Substratträgers ausgerichtet ist. Damit können die Enden der Führungsschiene gegenüber den Enden des übrigen Substratträgers bzw. der Substratträgerplatte verdreht werden.

Ein derartiges Drehlager kann vorzugsweise aus einem Kunststoffmaterial insbesondere in Form von Peek-Lagerblöcken mit einer Edelstahlwelle als Drehachse gefertigt sein.

Vorzugsweise kann das mittige oder zentrale Lager das einzige Lager sein. Allerdings können bei entsprechenden Dimensionen des Substratträgers ein oder mehrere seitliche Lager, insbesondere in Form von Loslagern erforderlich sein.

Vorzugsweise ist ein derartiges seitliches Loslager als Kugel- oder Rollenlager ausgebildet, welches eine Bewegung der Enden der Führungsschiene senkrecht zur Substratträgerebene ermöglicht, also die Drehachse parallel zur Längsseite des Substratträgers ausgerichtet ist.

Vorzugsweise ist zwischen Führungsschiene und Substratträger eine Einrichtung zur Dreh- oder Bewegungsbegrenzung vorgesehen, die eine Begrenzung der gegenseitigen Bewegung von Führungsschiene und Substratträger zueinander ermöglicht. Auf diese Weise wird verhindert, dass zu starke Bewegungen oder Verformungen der einzelnen Teile zu Kollisionen beim Transport des Substratträgers in der Vakuumanlage führen.

Eine entsprechende Dreh- oder Bewegungsbegrenzung kann als separates Bauteil ausgeführt sein oder in einem entsprechenden Lager, insbesondere seitlichen Loslager integriert sein.

### Kurze Beschreibung der Zeichnungen

Weitere Vorteile, Kennzeichen und Merkmale der vorliegenden Erfindung werden bei der nachfolgenden detaillierten Beschreibung von bevorzugten Ausführungsbeispielen deutlich. Die Figuren zeigen hierbei in rein schematischer Weise in

Fig.1 eine teilweise Seitenansicht eines ersten Substratträgers;

Fig.2 eine perspektivische Ansicht eines Lagers der Führungsschiene des Substratträgers aus Figur 1;

Fig.3 eine Draufsicht auf das Lager aus Figur 2;

Fig.4 eine Schnittansicht entlang der Schnittlinie A-A aus Figur 3;

Fig.5 eine Seitenansicht des Lagers aus den Figuren 2 bis 4;

Fig.6 eine teilweise Seitenansicht eines weiteren Substratträgers;

Fig.7 eine perspektivische Ansicht eines Drehlagers des Substratträgers aus Figur 6;

Fig.8 eine Draufsicht auf das Drehlagers aus Figur 7;

Fig.9 eine Schnittansicht entlang der Schnittlinie A-A aus Figur 8;

Fig.10 eine perspektivische Ansicht eines Rollenlagers des Substratträgers aus Figur 6;

Fig.11 eine Draufsicht auf das Rollenlager aus Figur 10;

Fig.12 eine Schnittansicht des Rollenlagers aus Figur 11 entlang der Schnittlinie A-A;

Fig.13 eine Seitenansicht des Rollenlagers aus den Figuren 10 bis 12;

Fig.14 eine teilweise Seitenansicht eines weiteren Substratträgers;

Fig.15 eine perspektivische Ansicht eines Bewegungsbegrenzers des Substratträgers aus Figur 14;

Fig.16 eine Draufsicht auf den Bewegungsbegrenzer aus Figur 15; und in

Fig.17 eine Schnittansicht des Bewegungsbegrenzers aus Figur 16 entlang der Schnittlinie A-A.

### Weg(e) zur Ausführung der Erfindung

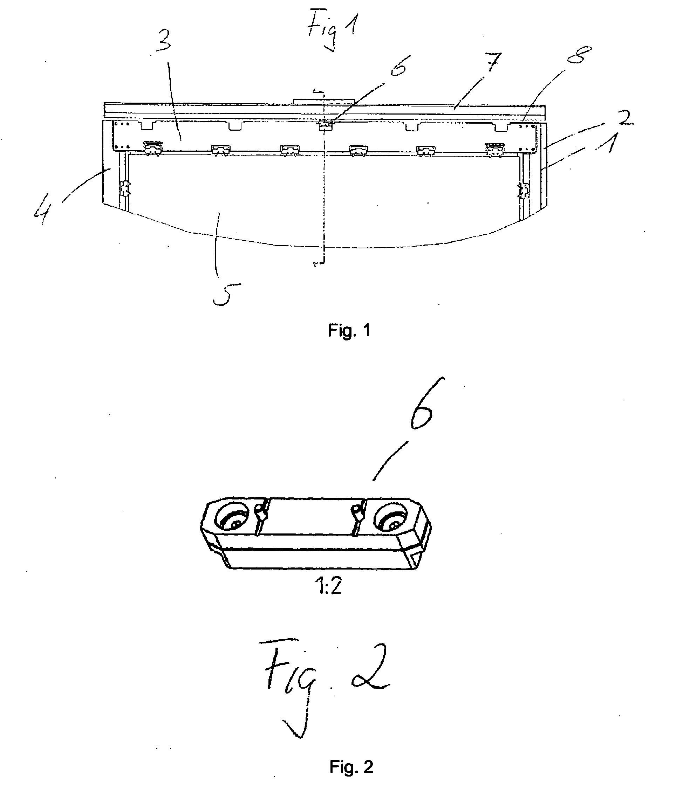

Figur 1 zeigt in einer teilweisen Seitenansicht einen erfindungsgemäßen Substratträger 1 der aus mehreren Rahmenteilen 2 bis 4 zusammengebaut ist und in der Mitte ein Substrat 5 aufnehmen kann.

An dem in Figur 1 oben dargestellten Rahmenteil 3 in Form einer länglichen Platte ist mittig ein Festlager 6 vorgesehen, über welches an der oberen Längsseite des Substraträgers 1 eine Führungsschiene 7 angeordnet ist, welche ein oder mehrere Magneten (nicht dargestellt) aufweisen kann. Durch die beabstandete Anordnung der Führungsschiene 7 von dem oberen Rahmenteil 3 durch das Festlager 6 ist ein Spalt 8 zwischen der Führungsschiene 3 und dem Substratträger 1 bzw. dem oberen Rahmenteil 3 gegeben. Damit können die freien Enden der Führungsschiene 7 sich gegenüber dem Substratträger 1 bzw. dem oberen Rahmenteil 3 bewegen, ohne dass es zu einem Abrieb zwischen der Führungsschiene 7 und dem oberen Rahmenteil 3 kommt. Insbesondere ist durch die "weiche" Auslegung des oberen Rahmenteils 3, beispielsweise in Form einer Alu-Platte, eine Verwindung des Substratträgers 1 gegenüber der Führungsschiene 7 möglich, ohne dass es zu einem Partikelabrieb kommen kann, der zu einer Belastung der Vakuumkammer oder der Störung von elektrischen oder mechanischen Einrichtungen bzw. der darin durchgeführten Beschichtungsprozesse oder aufgebrachten Beschichtungen führen könnte.

Das Festlager 6 ist in den Figuren 2 bis 5 näher dargestellt.

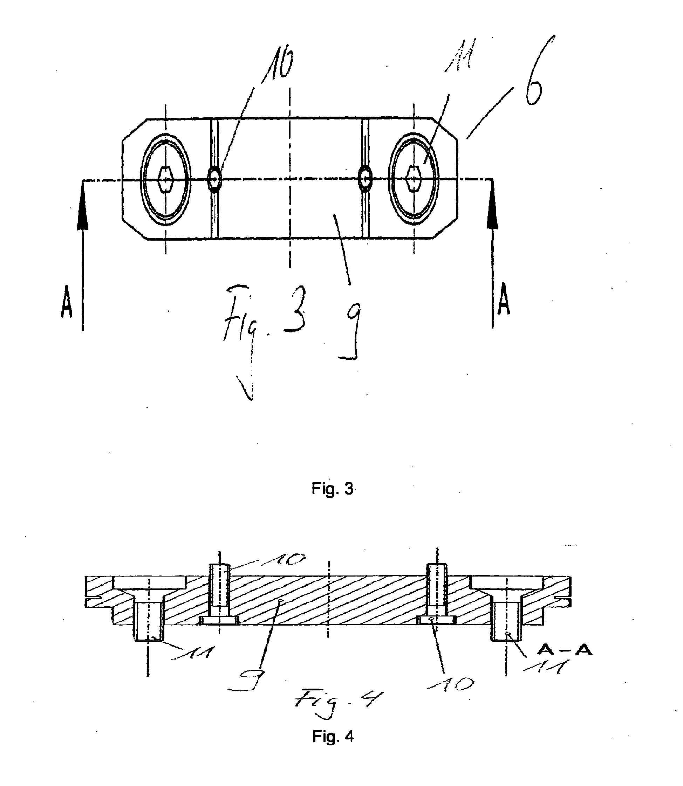

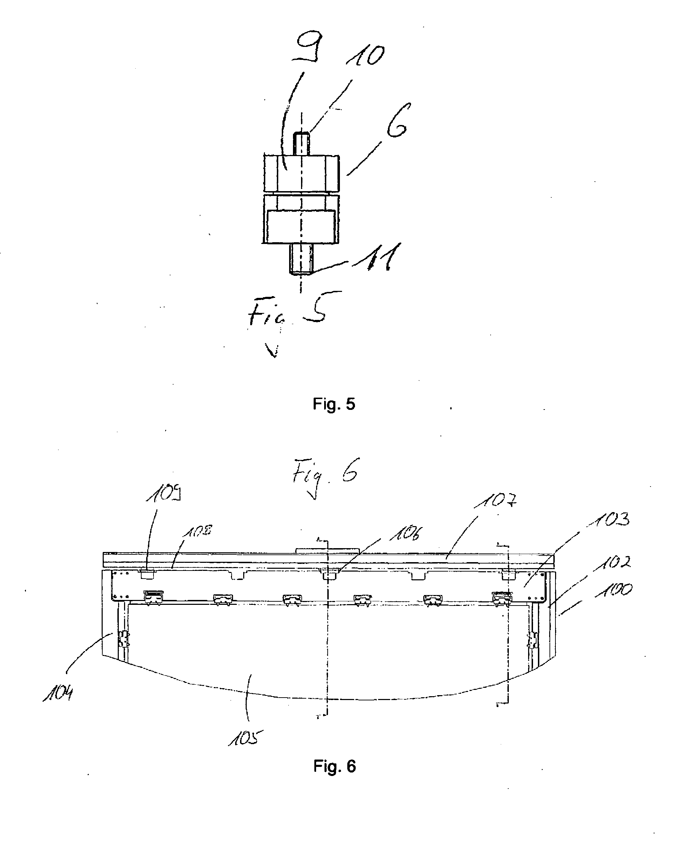

In Figur 2 ist eine perspektivische Darstellung des Festlagers gezeigt, während in der Figur 3 eine Draufsicht und in der Figur 4 eine Schnittansicht entlang der Schnittlinie A-A der Figur 3 zu sehen sind. Figur 5 zeigt das Festlager 6 in einer Seitenansicht von der schmalen Seite.

Wie den Figuren 2 bis 5 zu entnehmen ist, weist das Festlager 6 einen Lagerkörper 9 auf, in dem Bohrungen oder Ausnehmungen vorgesehen sind, um Schrauben 11 und 10 aufzunehmen, die in entsprechende Gewindeausnehmungen oder -bohrungen des Rahmenteils 3 bzw. der Führungsschiene 7 eingeschraubt werden können. Damit kann eine beabstandete und zugleich feste sowie steife Verbindung zwischen den Rahmenteil 3 des Substraträgers 1 sowie der Führungsschiene 7 erzielt werden.

Die Figur 6 zeigt eine weitere Ausführungsform eines erfindungsgemäßen Substraträgers 100, welcher ebenfalls aus Rahmenteilen 102 bis 104 zusammengebaut ist und ein Substrat 105 aufnehmen kann.

Die Führungsschiene 107 ist wiederum über ein mittiges bzw. zentrales Lager 106 mit dem oberen Rahmenteil 103 verbunden, wobei zusätzlich an den Enden der Führungsschiene 107 weitere Lager 109 (seitliche Loslager) vorgesehen sind. Auch in diesem Ausführungsbeispiel ist die Führungsschiene 107 von dem Rahmenteil 103 beabstandet, so dass ein Spalt 108 zwischen diesen Teilen ausgebildet ist, welcher einen Abrieb bei einer Bewegung von Führungsschiene 107 und Rahmenteil 103 zueinander weitgehend verhindert.

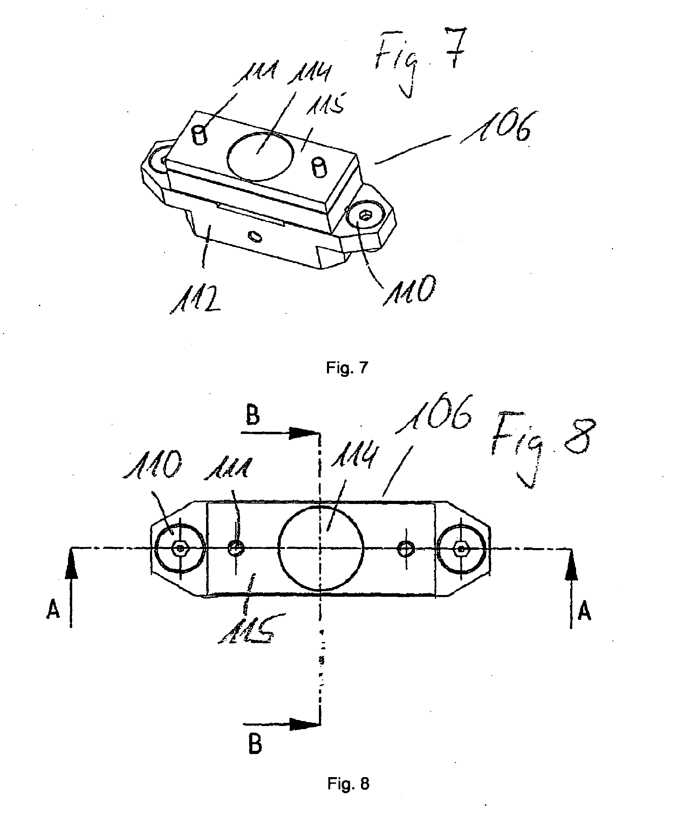

Bei der Ausführungsform des Substratträgers 100 ist als zentrales oder mittiges Lager ein Drehlager 106 vorgesehen, welches zwei gegeneinander verdrehbare Lagerkörper 112 und 115 aufweist, wie in den Figuren 7 bis 9 in einer perspektivischen Darstellung, eine Draufsicht und eine Schnittansicht zu sehen ist.

Die beiden verdrehbaren Lagerkörper 112 und 115 können beispielsweise aus einem Kunststoff gefertigt sein, wobei hier insbesondere ein für Hochvakuumbedingungen geeigneter Kunststoff, wie beispielsweise Peek-Kunststoff gewählt werden kann. Zur drehbaren Verbindung der Lagerkörper 112 und 115 ist eine Welle 114 vorgesehen, welche beispielsweise aus Edelstahl gebildet sein kann.

Die beiden Lagerkörper 112 und 115 sind jeweils über Schrauben 110 bzw. 111 an der Führungsschiene 107 bzw. dem oberen Rahmenteil 103 des Substratträgers 100 angeordnet.

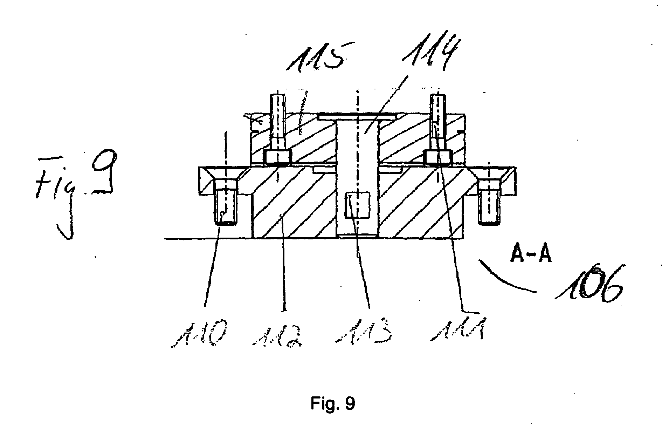

Wie sich insbesondere aus der Figur 9 ergibt, kann an der Welle 114 ein Bereich 113 vorgesehen sein, der beispielsweise durch Zusammenwirken mit einem entsprechenden quer verlaufenden Zapfen oder einem Gewindebolzen als axiale Befestigung oder Sicherung des oberen Lagerteils dient. Im Übrigen ermöglicht jedoch die beabstandete Drehlagerung der Führungsschiene 107 zum oberen Rahmenteil 103 eine reibungsarme Verdrehung bzw. Verwindung der Führungsschiene 107 gegenüber dem restlichen Substratträger 100.

Wie aus der Figur 6 zu erkennen ist, ist die Führungsschiene 107 an ihren Enden zusätzlich zum zentralen oder mittigen Lager 106 über Rollenlager 109 gelagert, die eine Bewegung der Enden der Führungsschiene 107 senkrecht zur Substratträgerebene ermöglichen. Entsprechend ist die Drehachse des Rollenlagers 109 auch parallel zur Führungsschiene 107 bzw. zur Längsseite des Substratträgers 100 angeordnet.

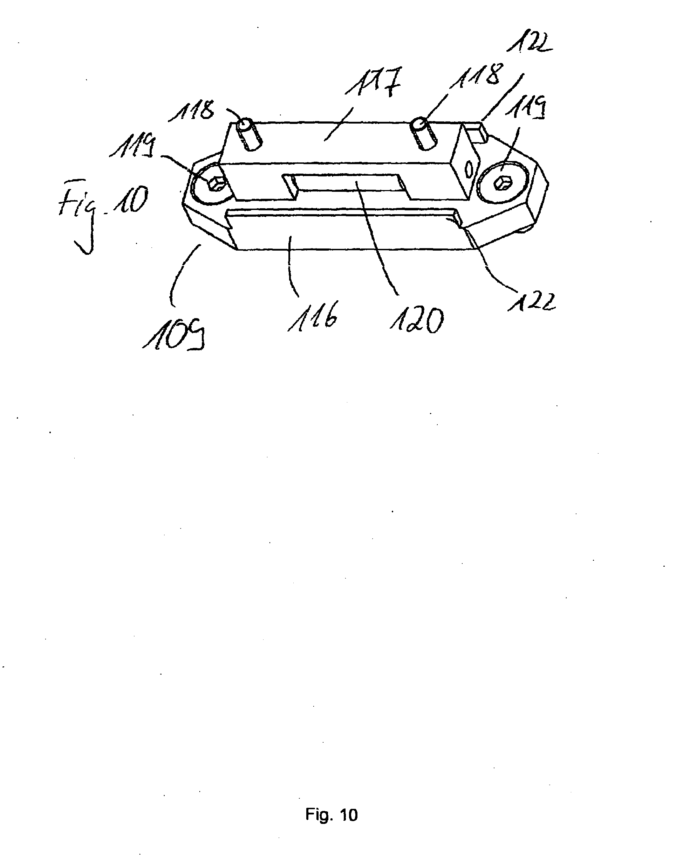

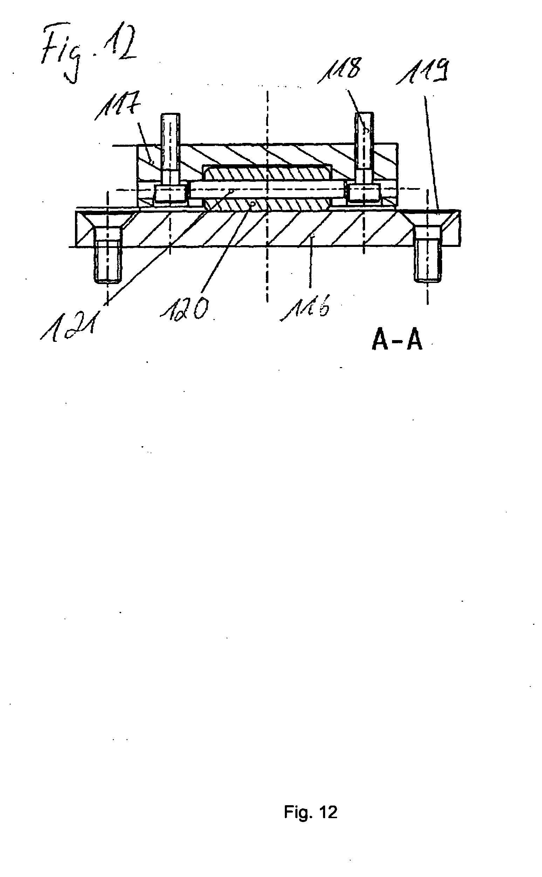

Die Figur 10 zeigt das Rollenlager 109 in einer perspektivischen Darstellung, wobei das Lager zwei Lagerkörper 116 und 117 aufweist, die jeweils über Schraubverbindungen 119 und 118 an den jeweiligen Komponenten, nämlich Führungsschiene 107 und oberes Rahmenteil 103 des Substratträgers 100 angeordnet werden. Zwischen den Lagerkörpern 116 und 117 ist eine drehbare Rolle 120 vorgesehen, die um eine Achswelle 121, wie insbesondere in Figur 12 zu sehen ist, drehbar ist und damit eine Bewegung des oberen Lagerkörpers 117 zum unteren Lagerkörper 116 ermöglicht.

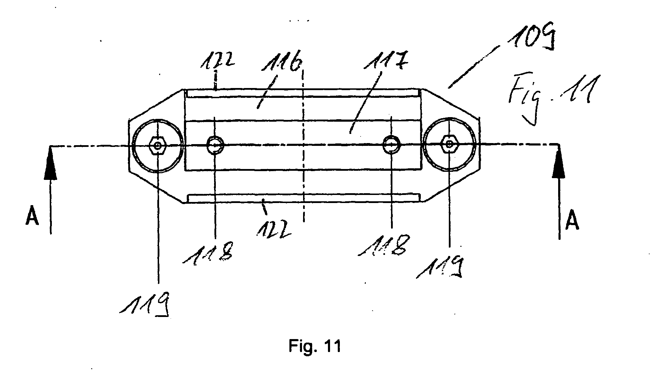

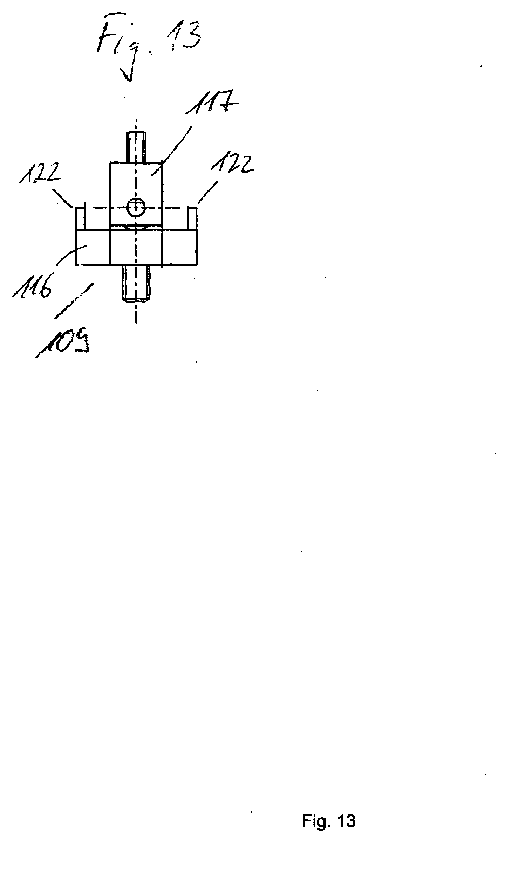

Wie die Figuren 10 bis 13 zeigen, ist der untere Lagerkörper 116 breiter als der obere Lagerkörper 117, wobei am unteren Lagerkörper 116 entlang den Längsseiten Stege 122 vorgesehen sind, die die Bewegung des oberen Lagerkörpers 117 begrenzen.

An Stelle eines Rollenlagers können auch andere Lager, wie Kugellager oder dergleichen vorgesehen werden.

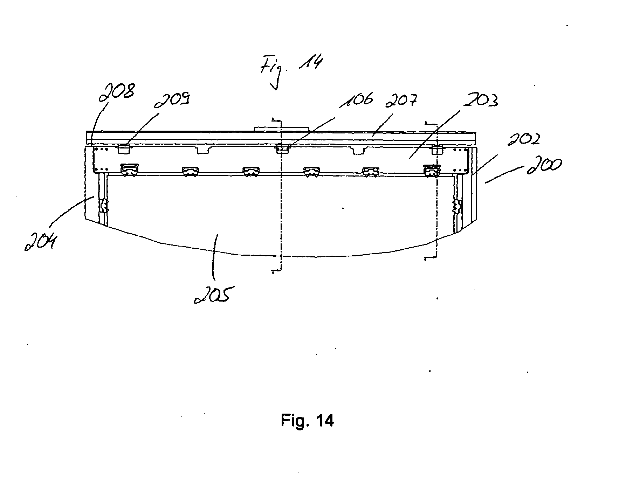

Die Figur 14 zeigt in einer teilweisen Seitenansicht, die vergleichbar den Ansichten der Figuren 1 und 6 ist, eine dritte Ausführungsform eines erfindungsgemäßen Substraträgers 200, welcher wiederum durch Rahmenteile 202, 203 und 204 gebildet ist, die zwischen sich das Substrat 205 aufnehmen. Auch bei dieser Ausführungsform ist mittig bzw. zentral am oberen Rahmenteil 203 ein Drehlager 106 vorgesehen, welches identisch zur Ausführungsform der Fig. 6 ist und die drehbare Lagerung der Führungsschiene 207 beabstandet zum oberen Rahmenteil 203 ermöglicht, so dass auch hier wiederum zwischen Führungsschiene 207 und oberen Rahmenteil 203 des Substratträgers 200 ein Spalt 208 ausgebildet ist.

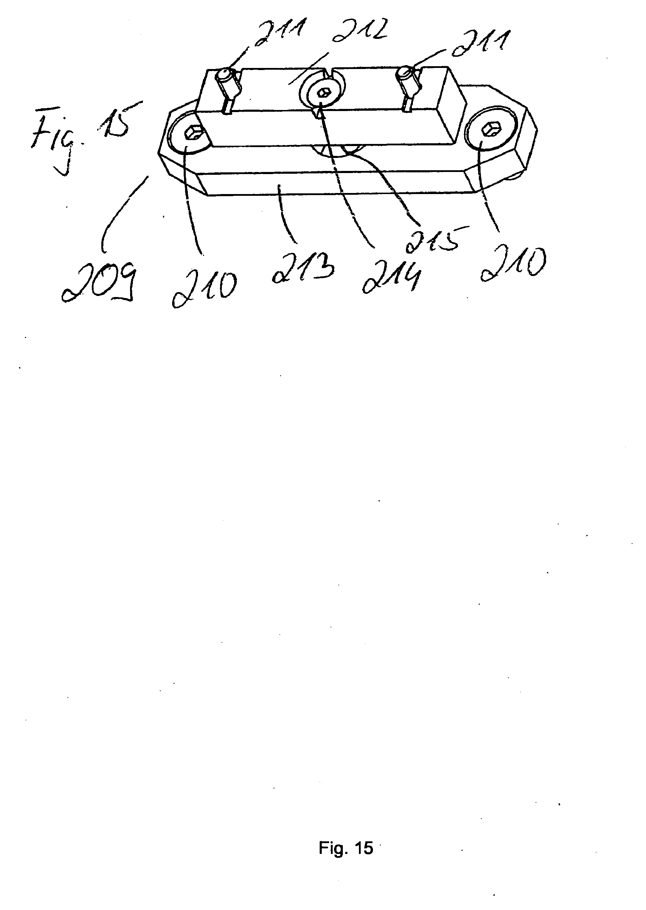

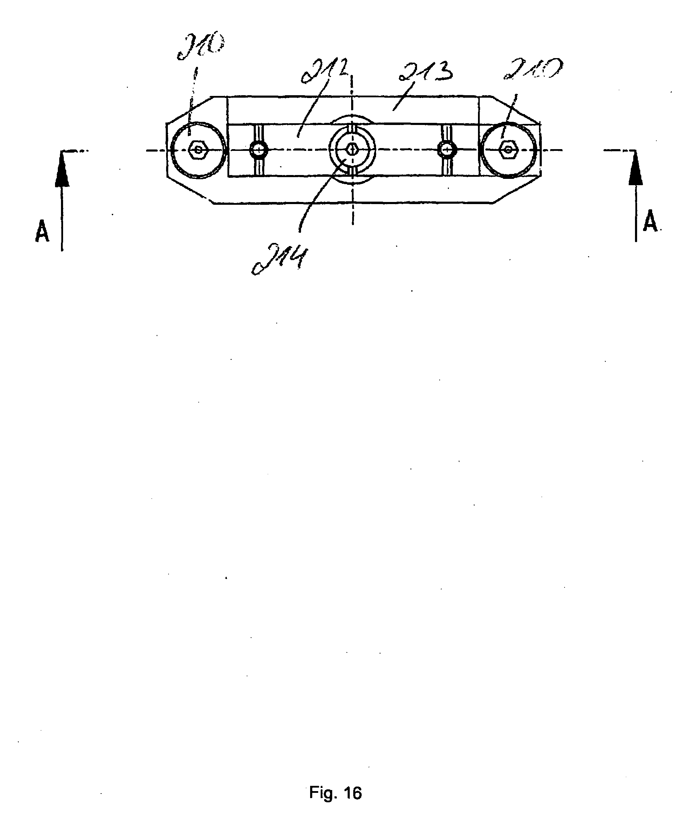

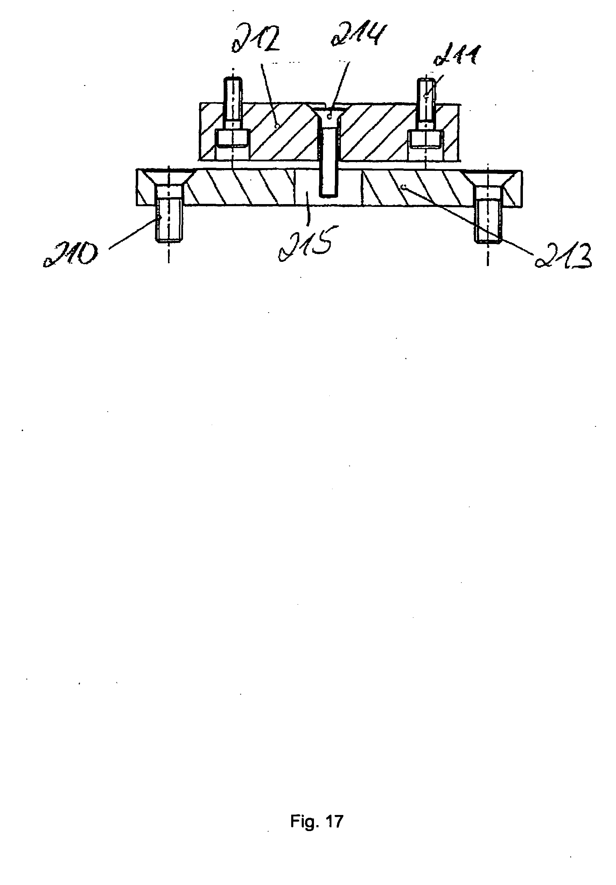

Anstelle der bei der Ausführungsform des Substratträgers 100 an den Enden der Führungsschiene 107 vorgesehenen Rollenlagern 109 sind bei der Ausführungsform des Substraträgers 200 der Figur 14 an den Enden der Führungsschiene 207 Bewegungsbegrenzer 209 vorgesehen, die in den Figuren 15 bis 17 näher dargestellt sind. Die Figur 15 zeigt eine perspektivische Darstellung des Bewegungsbegrenzers 209, während die Figuren 16 und 17 eine Draufsicht (Figur 16) bzw. eine Schnittansicht entlang der Schnittlinie A-A der Figur 16 zeigen (Figur 17).

Der Bewegungsbegrenzer 209 weist zwei beabstandet zueinander angeordnete Begrenzerkörper 212 und 213 auf, die jeweils über Schraubverbindungen 210 bzw. 211 an der Führungsschiene 207 bzw. dem oberen Rahmenteil 203 angeordnet werden. Im an den Substratträgerkomponenten angeordneten Zustand bilden die beiden Begrenzerkörper 212 und 213 einen Spalt zwischen sich aus, so dass eine berührungslose Bewegung der Begrenzerkörper 212 und 213 zueinander möglich ist.

In dem Begrenzerkörper 213, ist, wie insbesondere in Figur 17 zu erkennen ist, eine zylinderförmige Ausnehmung 215 vorgesehen, in die eine durch den oberen Begrenzerkörper 212 hindurch geführte Schraube 214 mit ihrem Gewindestift hineinragt. An Stelle einer derartigen Schraubenkonstruktion kann auch eine andere Stiftausbildung, wie beispielsweise eine integrale Stiftausbildung am Begrenzerkörper 212 oder das Vorsehen eines entsprechenden Bolzens oder dergleichen in Erwägung gezogen werden. Wesentlich ist, dass der Schraubenstift durch die Ausnehmung 215 lediglich einen begrenzten Bewegungsraum aufweist, so dass die Schraube 214 nach einem bestimmten Bewegungsumfang an dem unteren Begrenzerkörper 213 anschlägt und somit die gegenseitige Bewegung von Führungsschiene 207 und oberem Rahmenteil 203 begrenzt.

## Patentansprüche

1. Vorrichtung zum Transport von Substraten durch Vakuumkammern, insbesondere Beschichtungsanlagen mit einem Substratträger (1,100,200), auf oder an dem das Substrat angeordnet werden kann, wobei der Substratträger mindestens eine Führungsschiene (7,107,207) aufweist, die sich entlang mindestens einer Seite des Substratträgers erstreckt,
**dadurch gekennzeichnet, dass** die Führungsschiene mit Abstand zum Substratträger über ein oder einige wenige beabstandete Lager (6,106,109) gehalten ist.

2. Vorrichtung nach Anspruch 1,
**dadurch gekennzeichnet, dass** die Führungsschiene (7,107,207) entlang einer Längsseite in Längsrichtung angeordnet ist.

3. Vorrichtung nach Anspruch 1 oder 2,
**dadurch gekennzeichnet, dass** der Substratträger (1,100,200) eine flache, platten-, scheiben- oder rahmenartige Form aufweist, auf oder an welchem großflächige, flache Substrate, insbesondere Glassubstrate anbringbar sind.

4. Vorrichtung nach einem der vorhergehenden Ansprüche,
**dadurch gekennzeichnet, dass** die Führungsschiene (7,107,207) mittig oder in einem Zentralbereich am Substratträger gelagert ist.

5. Vorrichtung nach einem der vorhergehenden Ansprüche,
**dadurch gekennzeichnet, dass** das mittige oder zentrale Lager (6,106) ein Fest- oder Loslager, insbesondere Drehlager ist.

6. Vorrichtung nach Anspruch 5,
**dadurch gekennzeichnet, dass** die Drehachse des Drehlagers (106) in der Ebene des Substratträgers angeordnet und/oder im Wesentlichen senkrecht zur Seite des Substratträgers ausgerichtet ist.

7. Vorrichtung nach Anspruch 5 oder 6,
**dadurch gekennzeichnet, dass** das Drehlager (106) mindestens einen, vorzugsweise zwei verdrehbare Kunststoff-Lagerblöcke (112,115), insbesondere Peek-Blöcke, und/oder eine Welle (114), vorzugsweise aus Edelstahl umfasst.

8. Vorrichtung nach Anspruch 5,
**dadurch gekennzeichnet, dass** das Festlager (6) durch Schraubverbindungen (10,11) und/oder einen Zwischenblock (9) realisiert ist.

9. Vorrichtung nach einem der vorhergehenden Ansprüche,
**dadurch gekennzeichnet, dass** das mittige oder zentrale Lager (6,106) das einzige Lager ist.

10. Vorrichtung nach einem der Ansprüche 1 bis 8,
**dadurch gekennzeichnet, dass** neben dem mittigen oder zentralen Lager (6,106) ein oder mehr seitliche Lager (109), insbesondere Loslager vorgesehen sind.

11. Vorrichtung nach Anspruch 10,
**dadurch gekennzeichnet, dass** das Loslager (109) ein Kugel- oder Rollenlager, insbesondere mit einer Drehachse parallel zur Längsseite des Substratträgers ist, welches vorzugsweise in Verbindung mit dem mittigen oder zentralen Drehlager wirkt.

12. Vorrichtung nach einem der vorhergehenden Ansprüche,
**dadurch gekennzeichnet, dass** der Substratträger an der Seite, an der die Führungsschiene angeordnet ist, ein elastisches Material, insbesondere eine elastische metallische Platte (103) aufweist, die insbesondere mit dem mittigen oder zentralen Festlager wie eine Blattfeder wirkt.

13. Vorrichtung nach einem der vorhergehenden Ansprüche,
**dadurch gekennzeichnet, dass** Führungsschiene und/oder Substratträger eine Dreh- oder Bewegungsbegrenzung (122,209) aufweisen, die insbesondere eine gegenseitige Bewegung der Enden der Führungsschiene zu dem Substratträger begrenzen.

14. Vorrichtung nach Anspruch 13,
**dadurch gekennzeichnet, dass** die Dreh- oder Bewegungsbegrenzung als separates Bauteil (209) ausgeführt ist oder in einem Lager (109) integriert ist.

15. Vorrichtung nach Anspruch 13 oder 14,
**dadurch gekennzeichnet, dass** die Dreh- oder Bewegungsbegrenzung einen Stift (214), der am Substratträger oder der Führungsschiene angeordnet ist, und einen Körper mit einer Ausnehmung (215) oder einem Hohlraum umfasst, der gegenüberliegend dem Stift und diesen umgebend an der Führungsschiene oder dem Substratträger vorgesehen ist, so dass der Stift eine begrenzte Bewegung in der Ausnehmung oder dem Hohlraum ausführen kann.

16. Vorrichtung nach Anspruch 13 oder 14,
**dadurch gekennzeichnet, dass** die Dreh- oder Bewegungsbegrenzung durch zwei die Bewegung eines Lagerteils begrenzende Elemente (122) gebildet ist.

17. Vorrichtung nach einem der vorhergehenden Ansprüche,
**dadurch gekennzeichnet, dass** die Führungsschiene (7,107,207) magnetisch ist oder einen oder mehrere Magneten umfasst.

## Claims

1. Device for transporting substrates through vacuum chambers, especially coating machines with a substrate carrier (1,100, 200), on or at which the substrate can be arranged, wherein the substrate carrier has at least one guide rail (7,107, 207) which extends along at least one side of the substrate carrier.
**characterised by** the fact that
the guide rail is kept apart from the substrate carrier by one or several bearings spaced apart (6, 106, 109).

2. Device in accordance with claim 1,
**characterised by** the fact that
the guide rail (7, 107, 207) is arranged along a longitudinal side in the longitudinal direction.

3. Device in accordance with claim 1 or 2,
**characterised by** the fact that
the substrate carrier (1,100, 200) has a flat, plate-like, disk-like or frame-like shape on or at which large-surface, flat substrates, especially glass substrates, are attachable.

4. Device in accordance with any of the previous claims,
**characterised by** the fact that
the guide rail (7, 107, 207) is mounted centrally or in a central area at the substrate carrier.

5. Device in accordance with any of the previous claims,
**characterised by** the fact that
the central or central bearing (6, 106) is a fixed or floating bearing, especially a pivot bearing.

6. Device in accordance with claim 5,
**characterised by** the fact that
the rotation axis of the pivot bearing (106) is arranged in the plane of the substrate carrier and/or is aligned essentially perpendicularly to the side of the substrate carrier.

7. Device in accordance with claim 5 or 6,
**characterised by** the fact that
the pivot bearing (106) comprises at least one, preferably two rotatable plastic bearing blocks (112, 115), especially PEEK blocks, and/or a shaft (114), preferably of stainless steel.

8. Device in accordance with claim 5,
**characterised by** the fact that
the fixed bearing (6) is realised by screw connections (10, 11) and/or an intermediate block (9).

9. Device in accordance with any of the previous claims,
**characterised by** the fact that, the middle or central bearing (6, 106) is the sole bearing.

10. Device in accordance with any of claims 1 to 8,
**characterised by** the fact that
beside the middle or central bearing (6, 106) is arranged one or more lateral bearings (109), especially floating bearings.

11. Device in accordance with claim 10,
**characterised by** the fact that
the floating bearing (109) is a ball or roller bearing, especially with a rotation axis parallel to the longitudinal side of the substrate carrier, said bearing acting preferably in connection with the middle or central pivot bearing.

12. Device in accordance with any of the previous claims,
**characterised by** the fact that
the substrate carrier at the side at which the guide rail is arranged has an elastic material, especially an elastic metallic plate (103), which especially acts with the middle or central fixed bearing like a leaf spring.

13. Device in accordance with any of the previous claims,
**characterised by** the fact that
the guide rail and/or substrate carrier has a rotation or movement limiter (122, 209), which especially limits mutual movement of the ends of the guide rail towards the substrate carrier.

14. Device in accordance with claim 13,
**characterised by** the fact that
the rotation or movement limiter is designed as a separate part (209) or is integrated into a bearing (109).

15. Device in accordance with claim 13 or 14,
**characterised by** the fact that
the rotation or movement limiter comprises a pin (214), which is arranged at the substrate carrier or the guide rail, and a body with a cutout (215) or a cavity, which is provided opposite the pin so as to surround it at the guide rail or the substrate carrier, such that the pin can execute a limited movement in the cutout or the cavity.

16. Device in accordance with claim 13 or 14,
**characterised by** the fact that
the rotation or movement limiter is formed by two elements (122) which limit the movement of a bearing part.

17. Device in accordance with any of the previous claims,
**characterised by** the fact that
the guide rail (7,107, 207) is magnetic or comprises one or more magnets.

## Revendications

1. Dispositif pour le transport de substrats par des chambres à vide, en particulier installations de revêtement avec un support de substrat (1, 100, 200) sur ou contre lequel le substrat peut être placé, le support de substrat présentant au moins un rail de guidage (7, 107, 207) qui s'étend le long d'au moins un côté du support de substrat,
**caractérisé en ce que** le rail de guidage est maintenu avec un espace par rapport au support de substrat par un ou quelques paliers seulement espacés (6, 106, 109).

2. Dispositif selon la revendication 1,
**caractérisé en ce que** le rail de guidage (7, 107, 207) est placé le long d'un grand côté dans le sens longitudinal.

3. Dispositif selon la revendication 1 ou 2,
**caractérisé en ce que** le support de substrat (1, 100, 200) présente une forme plate de type plaque, disque ou cadre, support sur ou contre lequel des substrats plats, de grande surface, en particulier des substrats en verre, peuvent être appliqués.

4. Dispositif selon l'une des revendications précédentes,
**caractérisé en ce que** le rail de guidage (7, 107, 207) est positionné au milieu ou dans une zone centrale sur le support de substrat.

5. Dispositif selon l'une des revendications précédentes,
**caractérisé en ce que** le palier du milieu ou central (6, 106) est un palier fixe ou un palier libre, en particulier un coussinet de pivotement.

6. Dispositif selon la revendication 5,
**caractérisé en ce que** le pivot du coussinet de pivotement (106) est placé dans le plan du support de substrat et/ou est aligné essentiellement perpendiculairement au côté du support de substrat.

7. Dispositif selon la revendication 5 ou 6,
**caractérisé en ce que** le coussinet de pivotement (106) comprend au moins un, de préférence deux blocs de coussinet en matière synthétique aptes à effectuer une torsion (112, 115), en particulier des coussinets en PEEK, et/ou un arbre (114), de préférence en acier inoxydable.

8. Dispositif selon la revendication 5,
**caractérisé en ce que** le palier fixe (6) est réalisé par des assemblages par vis (10, 11) et/ou un bloc intermédiaire (9).

9. Dispositif selon l'une des revendications précédentes,
**caractérisé en ce que** le palier du milieu ou central (6, 106) est le seul palier.

10. Dispositif selon l'une des revendications 1 à 8,
**caractérisé en ce qu'**un ou plusieurs paliers latéraux (109), en particulier des paliers libres, sont prévus près du palier du milieu ou central (6, 106).

11. Dispositif selon la revendication 10,
**caractérisé en ce que** le palier libre (109) est un roulement à billes ou un palier à rouleaux, en particulier avec un pivot parallèlement au grand côté du support de substrat qui agit de préférence en relation avec un coussinet de pivotement au milieu ou central.

12. Dispositif selon l'une des revendications précédentes,
**caractérisé en ce que** le support de substrat présente un matériau élastique, en particulier une plaque métallique élastique (103), sur le côté sur lequel le rail de guidage est placé, plaque métallique élastique qui agit comme un ressort à lame en particulier avec le palier fixe du milieu ou central.

13. Dispositif selon l'une des revendications précédentes,
**caractérisé en ce que** le rail de guidage et/ou le support de substrat présente une limitation de rotation ou de mouvement (122, 209) qui limitent en particulier un mouvement réciproque des extrémités du rail de guidage par rapport au support de substrat.

14. Dispositif selon la revendication 13,
**caractérisé en ce que** la limitation de rotation ou de mouvement est réalisée comme un composant séparé (209) ou est intégrée à un palier (109).

15. Dispositif selon la revendication 13 ou 14,
**caractérisé en ce que** la limitation de rotation ou de mouvement comprend une cheville (214) qui est placée sur le support de substrat ou sur le rail de guidage et un corps avec un évidement (215) ou un espace creux qui est prévu en face de la cheville et qui entoure celle-ci sur le rail de guidage ou le support de substrat si bien que la cheville peut effectuer un mouvement limité dans l'évidement ou dans l'espace creux.

16. Dispositif selon la revendication 13 ou 14,
**caractérisé en ce que** la limitation de rotation ou de mouvement est formée par deux éléments (122) qui limitent le mouvement d'une partie de palier.

17. Dispositif selon l'une des revendications précédentes,
**caractérisé en ce que** le rail de guidage (7, 107, 207) est magnétique ou comprend un ou plusieurs aimants.
